# EUROPÄISCHE PATENTSCHRIFT

(11) **EP 4 340 227 B1**
(45) Veröffentlichungstag und Bekanntmachung des Hinweises auf die Patenterteilung: **25.11.2026**
(21) Anmeldenummer: 23192942.3
(22) Anmeldetag: 23.08.2023
(51) Int. Cl.: H03M 7/30, G01S 7/41

(54) **VERFAHREN ZUR RECHNERGESTÜTZTEN ERZEUGUNG EINES DATENGETRIEBENEN MODELLS FÜR DIE RECHNERGESTÜTZTE VERARBEITUNG VON DIGITALEN SAR-ROHDATEN**
METHOD FOR COMPUTER-AIDED GENERATION OF A DATA-DRIVEN MODEL FOR THE COMPUTER-AIDED PROCESSING OF RAW DIGITAL SAR DATA
PROCÉDÉ DE GÉNÉRATION ASSISTÉE PAR ORDINATEUR D'UN MODÈLE PILOTÉ PAR DES DONNÉES POUR LE TRAITEMENT ASSISTÉ PAR ORDINATEUR DE DONNÉES BRUTES SAR NUMÉRIQUES

(30) Priorität: 19.09.2022 DE 102022123897
(43) Veröffentlichungstag der Anmeldung: 20.03.2024
(73) Patentinhaber: Deutsches Zentrum für Luft- und Raumfahrt e.V., 53227 Bonn (DE)
(72) Erfinder: Rizzoli, Paola, 80686 München (DE); Martone, Michele, 80686 München (DE); Gollin, Nicola, 82205 Gilching (DE); Krieger, Gerhard, 82131 Gauting (DE)
(74) Vertreter: Fink Numrich Patentanwälte PartmbB

(56) Entgegenhaltungen:
- MARTONE MICHELE ET AL: "Performance-Optimized Quantization for SAR and InSAR Applications", IEEE TRANSACTIONS ON GEOSCIENCE AND REMOTE SENSING, IEEE, USA, vol. 60, 7 June 2022 (2022-06-07), pages 1 - 22, XP011913215, ISSN: 0196-2892, [retrieved on 20220608], DOI: 10.1109/TGRS.2022.3181237
- ZHU XIAO XIANG ET AL: "Deep Learning Meets SAR: Concepts, models, pitfalls, and perspectives", IEEE GEOSCIENCE AND REMOTE SENSING MAGAZINE, IEEE, USA, vol. 9, no. 4, 9 February 2021 (2021-02-09), pages 143 - 172, XP011900397, ISSN: 2473-2397, [retrieved on 20220209], DOI: 10.1109/MGRS.2020.3046356
- DENG HAO ET AL: "Machine-Learning Based Nonlinerity Correction for Coarse-Fine SAR-TDC Hybrid ADC", 2020 IEEE 63RD INTERNATIONAL MIDWEST SYMPOSIUM ON CIRCUITS AND SYSTEMS (MWSCAS), IEEE, 9 August 2020 (2020-08-09), pages 265 - 268, XP033819119, DOI: 10.1109/MWSCAS48704.2020.9184523
- SCARNATI THERESA ET AL: "A deep learning approach to the Synthetic and Measured Paired and Labeled Experiment (SAMPLE) challenge problem", SPIE PROCEEDINGS; [PROCEEDINGS OF SPIE ISSN 0277-786X], SPIE, US, vol. 10987, 14 May 2019 (2019-05-14), pages 109870G - 109870G, XP060122434, ISBN: 978-1-5106-3673-6, DOI: 10.1117/12.2523458

## Beschreibung

Die Erfindung betrifft ein Verfahren zur rechnergestützten Erzeugung eines datengetriebenen Modells für die rechnergestützte Verarbeitung von digitalen SAR-Rohdaten sowie ein Verfahren und eine Vorrichtung zur rechnergestützten Verarbeitung von digitalen SAR-Rohdaten und ein Computerprogrammprodukt sowie ein Computerprogramm.

SAR-Systeme (SAR = Synthetic Aperture Radar) ermöglichen die Erzeugung von Bildern der Erdoberfläche über das Echo von Radarpulsen, die von einem bewegten Objekt und insbesondere einem Flugobjekt, wie z.B. einem Satelliten, ausgesendet werden. Im Rahmen der SAR-Datenverarbeitung nutzt man die Tatsache, dass durch die Bewegung des Objekts entsprechende Punkte auf der Erdoberfläche mit unterschiedlichen Abständen zum Objekt erfasst werden, was zu einer Frequenzverschiebung im Radarecho führt. Über eine geeignete Prozessierung kann hieraus ein digitales Bild der Erdoberfläche errechnet werden.

Da durch die Erfassung des Radarechos für eine Vielzahl von unterschiedlichen Positionen in Bewegungsrichtung des Objekts (auch als Azimut-Positionen bezeichnet) eine große Menge an Rohdaten anfällt, ist es aus dem Stand der Technik bekannt, die SAR-Rohdaten nach deren Digitalisierung zu quantisieren. Hierdurch wird der Speicherplatz für die Rohdaten bei deren Zwischenspeicherung auf dem bewegten Objekt vermindert und es wird eine geringere Datenrate (Bits pro Abtastung) bei der Übermittlung der Rohdaten an eine Bodenstation auf der Erdoberfläche benötigt. Dies ist wichtig, denn die Menge der auf dem bewegten Objekt befindlichen Daten sollte so gering wie möglich gehalten werden, da es bei typischen Weltraum-SAR-Missionen aufgrund der begrenzten Speicherkapazität an Bord und der begrenzten Kapazität zum Herunterladen von Daten ansonsten zu Engpässen kommt.

Aus dem Stand der Technik ist als Quantisierungstechnologie für SAR-Rohdaten die sog. BAQ-Quantisierung (BAQ = Block Adaptive Quantization) bekannt. Allgemein zeichnet sich eine BAQ-Quantisierung dadurch aus, dass die digitalen Datenabtastungen der SAR-Rohdaten in Datenblocks aufgeteilt werden und in jedem Datenblock die entsprechenden Quantisierungsstufen basierend auf einer oder mehreren Größen bestimmt werden, die in Abhängigkeit von den Werten der digitalen Datenabtastungen des jeweiligen Datenblocks ermittelt werden. Die zur Bestimmung der Quantisierungsstufen herangezogenen Größen können z.B. die Gesamtleistung bzw. die mittlere Leistung der Datenabtastungen innerhalb eines Datenblocks umfassen, um basierend darauf die Quantisierungsstufen in einen Bereich zu legen, in dem die meisten Werte der Datenabtastungen liegen.

In den Druckschriften [1] und [2] sind herkömmliche BAQ-Quantisierungsverfahren beschrieben, bei denen für die Quantisierung aller Datenblocks die gleiche Bitrate (d.h. Anzahl von Bits pro quantisierter Datenabtastung) verwendet werden.

Aus der Druckschrift [3] ist eine dynamische FDBA-Quantisierung (FDBA = Flexible Dynamic Block Adaptive Quantization) für SAR-Rohdaten bekannt. Dabei wird die Bitrate der Quantisierung der jeweiligen Datenblocks dynamisch in Abhängigkeit vom Signal-zu-Rausch-Verhältnis der Datenabtastungen innerhalb eines Datenblocks festgelegt.

Aus der Druckschrift [4] ist eine adaptive BAQ-Quantisierung für SAR-Rohdaten bekannt, bei der die Bitrate der Quantisierung der jeweiligen Datenblocks (d.h. der BAQ-Blocks mit typischerweise ca. 100 Abtastungen) im Hinblick auf Parameter optimiert ist, die aus SAR-Bildern der Rohdaten bzw. aus weitergehend prozessierten SAR-Produkten (z.B. SAR-Interferogrammen) gewonnen sind. In diesem Verfahren wird eine A-Priori-Information über die lokale Verteilung von Rückstreusignalen für den gerade erfassten Abschnitt auf der Erdoberfläche benötigt.

Die BAQ-Quantisierungen mit adaptiver Bitrate gemäß den Dokumenten [3] und [4] weisen den Nachteil auf, dass größere Mengen an Daten für die Vorschrift zur Festlegung der Bitraten (z.B. in der Form von Look-up-Tabellen) bzw. für eine entsprechende A-Priori-Information anfallen. Dies ist insbesondere bei der Durchführung der Quantisierung auf dem sich bewegenden Objekt, das die SAR-Rohdaten erfasst, problematisch, denn es müssen größere Datenmengen an das Objekt übertragen bzw. dort gespeichert werden. Ferner führt die Verwendung von Look-up-Tabellen und einer A-priori-Information zu einer erhöhten Berechnungskomplexität für die Quantisierung.

Die Druckschrift [6] offenbart die Verwendung von neuronalen Netzen für prozessierte SAR-Bilder.

Aufgabe der Erfindung ist es, eine BAQ-Quantisierung mit adaptiven Bitraten der Datenblocks im Vergleich zum Stand der Technik zu verbessern.

Diese Aufgabe wird durch das Verfahren zur rechnergestützten Erzeugung eines datengetriebenen Modells gemäß Patentanspruch 1 bzw. das Verfahren zur rechnergestützten Verarbeitung von digitalen SAR-Rohdaten gemäß Patentanspruch 11 bzw. die Vorrichtung zur rechnergestützten Verarbeitung von digitalen SAR-Rohdaten gemäß Patentanspruch 15 bzw. das Computerprogrammprodukt gemäß Patentanspruch 16 bzw. das Computerprogramm gemäß Patentanspruch 17 gelöst. Weiterbildungen der Erfindung sind in den abhängigen Ansprüchen definiert.

Die Erfindung gemäß dem Verfahren des Patentanspruchs 1 zeichnet sich dadurch aus, dass ein datengetriebenes Modell in der Form eines neuronalen Netzes erzeugt wird, mit dem anschließend dynamisch entsprechende Bitraten zur Quantisierung von Datenblocks in digitalen SAR-Rohdaten festgelegt werden können. Mit anderen Worten ist das datengetriebene Modell zur Verarbeitung von digitalen SAR-Rohdaten vorgesehen. Solche SAR-Rohdaten umfassen in an sich bekannter Weise die rückgestreuten Radarechos von Radarpulsen, wobei die Rückstreuung in der Regel an der Erdoberfläche erfolgt. Die Radarpulse wurden dabei von einem oder mehreren Sendern zumindest eines Objekts ausgesendet, das sich in eine erste Richtung bewegt. Diese erste Richtung wird auch als Azimut-Richtung bezeichnet. Vorzugsweise handelt es sich bei dem zumindest einen Objekt um zumindest ein Flugobjekt, insbesondere um einen oder mehrere Satelliten.

Die Radarechos, die in den SAR-Rohdaten enthalten sind, wurden von einem oder mehreren Empfängern des zumindest einen Objekts empfangen. Die SAR-Rohdaten enthalten für jeden Empfänger einen Rohdatensatz aus einer Vielzahl von zeitlich aufeinander folgenden Datenabtastungen, denen jeweils eine Position in der ersten Richtung (Azimut-Richtung) und eine Position in einer zweiten Richtung zugeordnet sind, wobei die zweite Richtung auch als Range-Richtung bezeichnet wird. Diese Range-Richtung erstreckt sich senkrecht zur Azimut-Richtung. Im Rahmen der Verarbeitung der SAR-Rohdaten werden Datenblocks (auch als BAQ-Rohdatenblocks bezeichnet) von zeitlich aufeinander folgenden Datenabtastungen des Rohdatensatzes separat mit einer dem jeweiligen Datenblock zugeordneten Bitrate, welche die Anzahl von Bits pro quantisierter Datenabtastung im jeweiligen Datenblock festlegt, unter Verwendung einer Bitraten-Information quantisiert. Die Bitraten-Information gibt dabei für jeden Datenblock die zur Quantisierung des Datenblocks zu verwendende Bitrate an. Die Bitrate kann ein ganzzahliger Wert oder ggf. auch ein nicht-ganzzahliger Wert sein. Ein nicht-ganzzahliger Wert repräsentiert für einen jeweiligen Datenblock den arithmetischen Mittelwert der Bitraten der im jeweiligen Datenblock enthaltenen quantisierten Datenabtastungen. Das mit dem hier beschriebenen Verfahren erzeugte datengetriebene Modell ist zur Ermittlung der Bitraten-Information für den Rohdatensatz vorgesehen.

Die soeben beschriebene Quantisierung der Rohdaten ist nicht Teil des Verfahrens zur Erzeugung des datengetriebenen Modells. Vielmehr ist das datengetriebene Modell, das mit den nachfolgenden Schritten erzeugt wird, zur Verwendung bei der soeben beschriebenen Quantisierung vorgesehen. Die obige Beschreibung der Quantisierung ist jedoch für das Verständnis der nachfolgend erläuterten Schritte der Erzeugung des datengetriebenen Modells erforderlich.

Im Rahmen der Erzeugung des datengetriebenen Modells werden zuerst Trainingsdaten generiert, indem für eine Vielzahl von unterschiedlichen vorbekannten Rohdatensätzen, die im Aufbau den oben beschriebenen Rohdatensätzen entsprechen und in gleicher Weise in Datenblocks aufgeteilt sind, jeweils eine Bitraten-Information für die Datenblocks eines jeweiligen bekannten Rohdatensatzes erzeugt wird. Die Bitraten-Information entspricht der oben definierten Bitraten-Information, d.h. sie gibt für jeden Datenblock des jeweiligen vorbekannten Rohdatensatzes eine zugeordnete Bitrate der Quantisierung an, wobei die Bitrate ganzzahlig oder ggf. auch nicht-ganzzahlig sein kann. Die Erzeugung der Bitraten-Information erfolgt basierend auf einer Vorschrift, welche von Werten zumindest eines Parameters abhängt, die aus zumindest dem jeweiligen vorbekannten Rohdatensatz gewonnen werden. Vorzugsweise sind die Werte des zumindest einen Parameters Qualitätswerte für einen jeweiligen vorbekannten Rohdatensatz, insbesondere Qualitätswerte für die jeweiligen Datenblocks des jeweiligen vorbekannten Rohdatensatzes, oder Qualitätswerte für ein aus zumindest dem jeweiligen vorbekannten Rohdatensatz ermitteltes SAR-Produkt (z.B. SAR-Bild, SAR-Interferogramm und dergleichen), insbesondere Qualitätswerte für Bildpunkte oder Ausschnitte aus dem SAR-Produkt.

Als Vorschrift zur Erzeugung der Bitraten-Information können an sich bekannte Verfahren genutzt werden. Insbesondere können die Vorschriften verwendet werden, die in den Druckschriften [3] und [4] beschrieben sind. Nichtsdestotrotz können auch geeignete andere Vorschriften zur Erzeugung der Bitraten-Information festgelegt werden. Die Werte des zumindest einen Parameters werden vorzugsweise für jeden Datenblock des entsprechenden vorbekannten Rohdatensatzes festgelegt und bestimmen hierdurch die Bitrate der Quantisierung des jeweiligen Datenblocks.

Die mittels der vorbekannten Rohdatensätze generierten Trainingsdaten werden in einem nächsten Schritt zum Trainieren eines neuronalen Netzes verwendet. Neuronale Netze sind an sich bekannt und werden deshalb nicht im Detail beschrieben. Ein neuronales Netz enthält eine Vielzahl von Schichten aus Neuronen, die zur Bestimmung einer Ausgabe an einem Ausgang in Abhängigkeit von einer Eingabe an einem Eingang dienen. Zumindest eine Eingangsschicht aus Neuronen stellt den Eingang des neuronalen Netzes und zumindest eine Ausgangsschicht aus Neuronen stellt den Ausgang des neuronalen Netzes dar. Zwischen der zumindest einen Eingangsschicht und der zumindest einen Ausgangsschicht befinden sich eine oder mehrere versteckte Schichten aus Neuronen, welche die Eingabe am Eingang des neuronalen Netzes in eine entsprechende Ausgabe am Ausgang des neuronalen Netzes wandeln.

Erfindungsgemäß umfasst das neuronale Netz einen Eingang zur Eingabe eines Rohdatensatzes und einen Ausgang zur Ausgabe der Bitraten-Information für den eingegebenen Rohdatensatz. Das Training eines solchen neuronalen Netzes ist an sich bekannt und wird deshalb nicht im Detail beschrieben. Erfindungsgemäß wird ein Training basierend auf einem überwachten Lernen durchgeführt, da die Trainingsdaten die erwünschten Bitraten-Informationen für entsprechende vorbekannte Rohdatensätze angeben. Für das überwachte Lernen können an sich bekannte Verfahren genutzt werden, bei denen das Lernen auf einem Optimierungsziel basiert, gemäß dem die auf jeweiligen Eingaben basierenden Ausgaben des neuronalen Netzes möglichst gut mit den Trainingsdaten übereinstimmen sollen. Weiter unten werden Varianten eines überwachten Lernens beschrieben, die zum Trainieren des neuronalen Netzes im erfindungsgemäßen Verfahren verwendet werden können.

Das trainierte neuronale Netz stellt das erzeugte datengetriebene Modell im Sinne der Erfindung dar. Dieses datengetriebene Modell liefert die Bitraten-Information für die Quantisierung bei einer nachfolgenden Verarbeitung von SAR-Rohdaten.

Die Erfindung weist den Vorteil auf, dass ohne die explizite Implementierung einer Vorschrift und ohne die Verwendung einer A-priori-Information eine Bitraten-Information für die Quantisierung generiert werden kann. Hierfür wird ein geeignet gelerntes neuronales Netz genutzt, das ggf. flexibel angepasst werden kann, indem es bei Vorliegen von neuen vorbekannten Rohdatensätzen nochmals neu trainiert wird. Die Erfindung kann sowohl für SAR-Rohdaten eines monostatischen SAR-Systems (d.h. ein einziger SAR-Sensor, der sowohl als Sender als auch Empfänger fungiert) als auch für SAR-Rohdaten eines multistatischen SAR-Systems (d.h. mehrere SAR-Sensoren auf unterschiedlichen Plattformen, wobei die SAR-Sensoren als Sender und/oder Empfänger fungieren) verwendet werden.

In einer bevorzugten Variante des erfindungsgemäßen Verfahrens zur Erzeugung eines datengetriebenen Modells wird im Rahmen der Generierung der Trainingsdaten für einen jeweiligen vorbekannten Rohdatensatz eine SAR-Prozessierung durchgeführt, welche in an sich bekannter Weise die Ermittlung von einem oder mehreren SAR-Bildern aus zumindest dem jeweiligen vorbekannten Rohdatensatz (d.h. aus dem jeweiligen vorbekannten Rohdatensatz und ggf. einem oder mehreren weiteren Rohdatensätzen) enthält. Dabei werden aus Informationen, welche die SAR-Prozessierung liefert, die Werte des zumindest einen Parameters gewonnen. Vorzugsweise sind die Werte des zumindest einen Parameters Qualitätswerte für ein aus der SAR-Prozessierung gewonnenes SAR-Produkt (z.B. SAR-Interferogramm, Höhenmodell, Klassifizierungskarte und dergleichen), insbesondere Qualitätswerte für Bildpunkte oder Ausschnitte aus dem SAR-Produkt.

Unter einem SAR-Bild ist dabei eine zweidimensionale Bildinformation zu verstehen, welche für eine Vielzahl von Bildpunkten in der erfassten Szene (vorzugsweise ein Ausschnitt auf der Erdoberfläche) eine Amplitude und eine Phase angibt. Fließt bei der SAR-Prozessierung nur ein jeweiliger vorbekannter Rohdatensatz ein, erhält man auch nur ein SAR-Bild für den entsprechenden Rohdatensatz. Das oder die ermittelten SAR-Bilder können das Ergebnis der SAR-Prozessierung und in diesem Sinne ein SAR-Produkt darstellen, sie können jedoch ggf. auch ein Zwischenschritt dieser SAR-Prozessierung sein. Beispielsweise können in an sich bekannter Weise im Rahmen der SAR-Prozessierung aus entsprechenden SAR-Bildern SAR-Interferogramme als SAR-Produkte gewonnen werden, wobei in diesem Fall neben dem jeweiligen vorbekannten Rohdatensatz auch noch zumindest ein anderer vorbekannter Rohdatensatz bei der SAR-Prozessierung des jeweiligen vorbekannten Rohdatensatzes einfließt.

Die Werte des zumindest einen Parameters sind vorzugsweise mit entsprechenden Bildpunkten eines SAR-Bilds bzw. eines entsprechend weiterverarbeiteten Bilds (z.B. SAR-Intensitätsbild oder SAR-Interferogramm) verknüpft, wobei die Bildpunkte in an sich bekannter Weise jeweils mit einem entsprechenden Datenblock im jeweiligen vorbekannten Rohdatensatz verknüpft werden können, wobei die Datenabtastungen des verknüpften Datenblocks die Amplitude und Phase des zugehörigen Bildpunkts wesentlich mitbestimmen. Die Werte des zumindest einen Parameters an einem Bildpunkt legen somit die Bitrate der Quantisierung eines damit verknüpften Datenblocks in dem jeweiligen vorbekannten Rohdatensatz fest.

In einer Variante der soeben beschriebenen Ausführungsform des erfindungsgemäßen Verfahrens ist der zumindest eine Parameter die Standardabweichung der Verteilung der rückgestreuten Signale in einem Ausschnitt um einen Bildpunkt eines SAR-Bilds, das für den jeweiligen vorbekannten Rohdatensatz ohne Quantisierung oder nach einer Quantisierung mit konstanter Bitrate (d.h. fester Bitrate für alle Datenblocks) ermittelt wird. Dabei werden Werte der Standardabweichung für eine Vielzahl von Bildpunkten und insbesondere für alle Bildpunkte im SAR-Bild ermittelt. Wie oben erwähnt, können die entsprechenden Bildpunkte mit Datenblocks in dem jeweiligen vorbekannten Rohdatensatz verknüpft werden, so dass in Abhängigkeit der Werte der Standardabweichung Bitraten für die verknüpften Datenblocks festgelegt werden können. Der soeben beschriebene Parameter der Standardabweichung der Verteilung der rückgestreuten Signale wird auch in der Druckschrift [4] zur Ermittlung der Bitraten-Information genutzt.

In einer weiteren bevorzugten Ausführungsform ist der zumindest eine Parameter das Signal-zu-Quantisierungsrauschen-Verhältnis in einem Ausschnitt um einen Bildpunkt eines SAR-Bilds (d.h. das über den Ausschnitt gemittelte Signal-zu-Quantisierungsrauschen-Verhältnis), wobei das SAR-Bild das für den jeweiligen vorbekannten Rohdatensatz nach einer Quantisierung mit konstanter Bitrate (d.h. fester Bitrate für alle Datenblocks) ermittelt wird und wobei Werte des Signal-zu-Quantisierungsrauschen-Verhältnisses für eine Vielzahl von Bildpunkten in mehreren, für den jeweiligen vorbekannten Rohdatensatz ermittelten SAR-Bildern ermittelt werden, wobei sich die mehreren SAR-Bilder in der Bitrate der Quantisierung des jeweiligen vorbekannten Rohdatensatzes unterscheiden. Das Signal-zu-Quantisierungsrauschen-Verhältnis ist eine dem Fachmann hinlänglich bekannte Größe und wird beispielsweise in Druckschrift [4] definiert. Für die Werte des Signal-zu-Quantisierungsrauschen-Verhältnisses bei unterschiedlichen Quantisierungen kann dabei eine Anforderung, z.B. in der Form eines vorgegebenen Werts oder Wertebereichs, in der Vorschrift zur Erzeugung der Bitraten-Information definiert sein. Eine entsprechende Anforderung ist beispielsweise in der Druckschrift [4] näher definiert.

In einer weiteren bevorzugten Ausführungsform umfasst der zumindest eine Parameter den durch Quantisierung verursachten Kohärenzverlust in einem Ausschnitt um einen Bildpunkt eines SAR-Interferogramms (d.h. den über den Ausschnitt gemittelten Kohärenzverlust), wobei das SAR-Interferogramm aus dem jeweiligen vorbekannten Rohdatensatz und zumindest einem weiteren vorbekannten Rohdatensatz nach einer Quantisierung mit konstanter Bitrate (d.h. fester Bitrate für alle Datenblocks) ermittelt wird und wobei Werte des durch Quantisierung verursachten Kohärenzverlustes für eine Vielzahl von Bildpunkten für mehrere SAR-Interferogramme ermittelt werden, wobei sich die mehreren SAR-Interferogramme in der Bitrate der Quantisierung des jeweiligen vorbekannten Rohdatensatzes und des zumindest einen weiteren vorbekannten Rohdatensatzes unterscheiden. Die Ermittlung entsprechender SAR-Interferogramme, die Phasenunterschiede zwischen mehreren SAR-Bildern beschreiben, ist dem Fachmann hinlänglich bekannt. Ferner ist auch der obige Kohärenzverlust eine hinlänglich bekannte Größe, welche beispielsweise in der Druckschrift [4] beschrieben ist. Für die Werte des Kohärenzverlustes bei unterschiedlichen Quantisierungen kann dabei eine Anforderung, z.B. in der Form eines vorgegebenen Werts oder Wertebereichs, in der Vorschrift zur Erzeugung der Bitraten-Information definiert sein. Eine entsprechende Anforderung ist beispielsweise in der Druckschrift [4] näher definiert.

In einer weiteren Ausführungsform umfasst der zumindest eine Parameter die Standardabweichung der Verteilung des durch Quantisierung verursachten Phasenfehlers in einem Ausschnitt um einen Bildpunkt eines SAR-Interferogramms, das aus dem jeweiligen vorbekannten Rohdatensatz und zumindest einem weiteren vorbekannten Rohdatensatz nach einer Quantisierung mit konstanter Bitrate (d.h. fester Bitrate für alle Datenblocks) ermittelt wird, wobei Werte der Standardabweichung der Verteilung des durch die Quantisierung verursachten Phasenfehlers für eine Vielzahl von Bildpunkten für mehrere SAR-Interferogramme ermittelt werden, wobei sich die mehreren SAR-Interferogramme in der Bitrate der Quantisierung des jeweiligen vorbekannten Rohdatensatzes und des zumindest einen weiteren vorbekannten Rohdatensatzes unterscheiden. Der durch Quantisierung verursachte Phasenfehler ist eine hinlänglich bekannte Größe und wird beispielsweise in der Druckschrift [4] näher definiert. Für die Werte der Standardabweichung der Verteilung des durch Quantisierung verursachten Phasenfehlers bei unterschiedlichen Quantisierungen kann dabei eine Anforderung, z.B. in der Form eines vorgegebenen Werts oder Wertebereichs, in der Vorschrift zur Erzeugung der Bitraten-Information definiert sein. Eine entsprechende Anforderung ist beispielsweise in der Druckschrift [4] näher definiert.

In einer weiteren Ausgestaltung des erfindungsgemäßen Verfahrens werden die Werte des zumindest einen Parameters direkt aus den Datenabtastungen der Datenblocks des jeweiligen vorbekannten Rohdatensatzes gewonnen, ohne dass für die Gewinnung des zumindest einen Parameters eine SAR-Prozessierung durchgeführt wird, wobei eine solche SAR-Prozessierung die Ermittlung von SAR-Bildern aus zumindest dem jeweiligen vorbekannten Rohdatensatz enthält. Beispielsweise kann der zumindest eine Parameter das mittlere Signal-zu-Rausch-Verhältnis der Datenabtastungen in einem Datenblock in dem jeweiligen vorbekannten Rohdatensatz sein, wobei Werte des Signal-zu-Rausch-Verhältnisses für jeden Datenblock in dem jeweiligen vorbekannten Rohdatensatz ermittelt werden. Dieser Parameter wird auch in dem Verfahren der Druckschrift [3] verwendet.

Erfindungsgemäß kann ein beliebiges neuronales Netz zur Ermittlung der Bitraten-Information genutzt werden. Besonders praktikabel ist die Verwendung eines sog. Convolutional Neural Networks, das sehr gut für die Verarbeitung von Bildinformation geeignet ist. Der Aufbau von Convolutional Neural Networks ist dem Fachmann hinlänglich bekannt und wird deshalb nicht im Detail beschrieben. Ein Convolutional Neural Network enthält sog. Convolutional Layers, die am Eingang des neuronalen Netzes vorgesehen sind, wobei in der Regel auch sog. Polling Layers zur Datenreduktion vorgesehen sind. Die Convolutional Layers führen eine Faltung der zugeführten Daten mit einem Filterkernel durch. Mittels dieser Faltung können aus dem entsprechenden Rohdatensatzes bereits vorab Strukturen entsprechender SAR-Bilder extrahiert werden.

In einer weiteren bevorzugten Ausführungsform handelt es sich bei dem neuronalen Netz um ein tiefes neuronales Netz (englisch: deep neural network). Der Begriff des tiefen neuronalen Netzes ist dem Fachmann hinlänglich bekannt. Ein solches neuronales Netz zeichnet sich durch eine große Anzahl von versteckten Schichten aus und ermöglicht eine besonders gute Modellierung der Bitraten-Information. In einer besonders bevorzugten Ausführungsform ist das tiefe neuronale Netz ein Convolutional Neural Network.

In einer weiteren bevorzugten Ausführungsform ist das trainierte neuronale Netz auf einem oder mehreren FPGAs (FPGA = Field Programmable Gate Array) implementiert. FPGAs ermöglichen eine sehr effiziente Ausführung des neuronalen Netzes.

In einer Ausführungsform des erfindungsgemäßen Verfahrens erfolgt das Trainieren des neuronalen Netzes basierend auf einem überwachten Lernen, dessen Optimierungsziel durch ein Klassifikationsproblem repräsentiert wird, bei dem die Bitraten der jeweiligen Datenblocks in der Bitraten-Information am Ausgang des neuronalen Netzes jeweilige Klassen aus einer Vielzahl von Klassen darstellen. Mit dieser Ausführungsform wird somit ein neuronales Netz in der Form eines Klassifikators gelernt. Solche Lernverfahren sind dem Fachmann hinlänglich bekannt.

In einer weiteren Ausführungsform des erfindungsgemäßen Verfahrens erfolgt das Trainieren des neuronalen Netzes basierend auf einem überwachten Lernen, dessen Optimierungsziel durch ein Regressionsproblem repräsentiert wird, bei dem die Bitraten der jeweiligen Datenblocks in der Bitraten-Information am Ausgang des neuronalen Netzes jeweils eine positive reelle Zahl darstellen. Unüberwachte Lernverfahren basierend auf Regression sind dem Fachmann hinlänglich bekannt. Solche Lernverfahren haben den Vorteil, dass eine entsprechende Verlustfunktion (englisch: loss function), über welche das Optimierungsziel definiert wird, den Fehler zwischen einer jeweiligen Bitrate in der Bitraten-Information am Ausgang des neuronalen Netzes und der entsprechenden Bitrate gemäß den Trainingsdaten basierend auf der Differenz von zwei positiven reellen Zahlen quantifizieren kann.

Neben dem oben beschriebenen Verfahren zur Erzeugung eines datengetriebenen Modells betrifft die Erfindung ein Verfahren zur rechnergestützten Verarbeitung von digitalen SAR-Rohdaten, welche die rückgestreuten Radarechos von Radarpulsen umfassen, wobei die Radarpulse von einem oder mehreren Sendern zumindest eines Objekts ausgesendet wurden, das sich in eine erste Richtung bewegt, und die Radarechos von einem oder mehreren Empfängern des zumindest einen Objekts empfangen wurden, wobei die SAR-Rohdaten für jeden Empfänger einen Rohdatensatz aus einer Vielzahl von zeitlich aufeinander folgenden Datenabtastungen enthalten, denen jeweils eine Position in der ersten Richtung und eine Position in eine zweite Richtung senkrecht zur ersten Richtung zugeordnet sind. Im Rahmen der Verarbeitung der SAR-Rohdaten werden Datenblocks von zeitlich aufeinander folgenden Datenabtastungen des Rohdatensatzes separat mit einer dem jeweiligen Datenblock zugeordneten Bitrate, welche die Anzahl von Bits pro quantisierter Datenabtastung im jeweiligen Datenblock festlegt, unter Verwendung einer Bitraten-Information quantisiert, wobei die Bitraten-Information für jeden Datenblock die zugeordnete Bitrate angibt.

Im Rahmen dieses Verfahrens wird die Bitraten-Information mit einem datengetriebenen Modell generiert, das mit dem oben beschriebenen Verfahren zur rechnergestützten Erzeugung eines datengetriebenen Modells erzeugt wurde, d.h. die Erzeugung des datengetriebenen Modells ist nicht Teil des erfindungsgemäßen Verfahrens zur rechnergestützten Verarbeitung der SAR-Rohdaten (d.h. nicht Teil der Quantisierung). Im Falle, dass die generierte Bitraten-Information für eine oder mehrere Datenblocks jeweils eine nicht-ganzzahlige Bitrate enthält, werden die Bitraten für die einzelnen quantisierten Datenabtastungen des entsprechenden Datenblocks derart festgelegt, dass der arithmetische Mittelwert dieser Bitraten der nicht-ganzzahligen Bitrate des entsprechenden Datenblocks entspricht. Eine derartige Festlegung nicht-ganzzahliger Bitraten ist beispielsweise aus der Druckschrift [5] bekannt.

In einer alternativen Variante ist es auch möglich, dass die Erzeugung des datengetriebenen Modells, mit dem die Bitraten-Information in dem Verfahren zur Verarbeitung von SAR-Rohdaten generiert wird, Teil des Verfahrens zur Verarbeitung von SAR-Rohdaten ist. Mit anderen Worten wird die Bitraten-Information mit einem datengetriebenen Modell generiert, das während der Verarbeitung der SAR-Rohdaten mit dem oben beschriebenen Verfahren erzeugt wird.

In einer bevorzugten Variante des erfindungsgemäßen Verfahrens zum Verarbeiten von SAR-Rohdaten werden die mit dem Verfahren gewonnenen quantisierten Datenabtastungen auf dem zumindest einen Objekt, d.h. direkt nachgeschaltet zur Erfassung der SAR-Rohdaten, ermittelt. Die quantisierten Datenabtastungen werden anschließend an eine Bodenstation, d.h. eine Station auf der Erdoberfläche, übertragen. Das zumindest eine Objekt ist in diesem Fall vorzugsweise zumindest ein Flugobjekt, insbesondere zumindest ein Satellit.

Die Erfindung betrifft ferner eine Vorrichtung zum Verarbeiten von digitalen SAR-Rohdaten, wobei die Vorrichtung zur Durchführung des erfindungsgemäßen Verfahrens zur Verarbeitung von SAR-Rohdaten bzw. einer oder mehrerer bevorzugter Varianten dieses Verfahrens konfiguriert ist. Hierzu enthält die Vorrichtung einen Quantisierer, der dazu eingerichtet ist, im Rahmen der rechnergestützten Verarbeitung der SAR-Rohdaten Datenblocks von zeitlich aufeinander folgenden Datenabtastungen des Rohdatensatzes separat mit einer dem jeweiligen Datenblock zugeordneten Bitrate, welche die Anzahl von Bits pro quantisierter Datenabtastung im jeweiligen Datenblock festlegt, unter Verwendung einer Bitraten-Information zu quantisieren, wobei die Bitraten-Information für jeden Datenblock die zugeordnete Bitrate angibt, wobei der Quantisierer zur Generierung der Bitraten-Information ein datengetriebenes Modell enthält, das mit dem oben beschriebenen Verfahren zur Erzeugung eines datengetriebenen Modells vorab erzeugt wurde. Alternativ kann das datengetriebene Modell auch durch den Quantisierer erzeugt werden, d.h. das Modell liegt nicht vorab als erzeugtes Modell im Quantisierer vor, sondern wird während der SAR-Datenverarbeitung generiert. Vorzugsweise ist die Vorrichtung auf dem zumindest einen Objekt vorgesehen, das den oder die Sender bzw. den oder die Empfänger für die Erfassung der SAR-Rohdaten umfasst.

Die Erfindung betrifft darüber hinaus ein Computerprogrammprodukt mit einem auf einem maschinenlesbaren Träger gespeicherten Programmcode zur Durchführung des erfindungsgemäßen Verfahrens zur rechnergestützten Erzeugung eines datengetriebenen Modells bzw. zur Durchführung des erfindungsgemäßen Verfahrens zur rechnergestützten Verarbeitung von digitalen SAR-Rohdaten bzw. zur Durchführung einer oder mehrerer bevorzugter Varianten dieser Verfahren, wenn der Programmcode auf einem Rechner ausgeführt wird.

Die Erfindung betrifft ferner ein Computerprogramm mit einem Programmcode zur Durchführung des erfindungsgemäßen Verfahrens zur rechnergestützten Erzeugung eines datengetriebenen Modells bzw. zur Durchführung des erfindungsgemäßen Verfahrens zur rechnergestützten Verarbeitung von digitalen SAR-Rohdaten bzw. zur Durchführung einer oder mehrerer bevorzugter Varianten dieser Verfahren, wenn der Programmcode auf einem Rechner ausgeführt wird.

Ausführungsbeispiele der Erfindung werden nachfolgend anhand der beigefügten Figuren detailliert beschrieben.

Es zeigen:
- Fig. 1: eine schematische Darstellung, anhand der das im Rahmen der Erfindung verwendete SAR-Prinzip erläutert wird;
- Fig. 2: eine schematische Darstellung zur Erläuterung einer Ausführungsform des erfindungsgemäßen Verfahrens zur rechnergestützten Verarbeitung von digitalen SAR-Rohdaten; und
- Fig. 3: eine schematische Darstellung einer Ausführungsform eines erfindungsgemäßen Verfahrens zur Erzeugung eines datengetriebenen Modells für das Verfahren der Fig. 2.

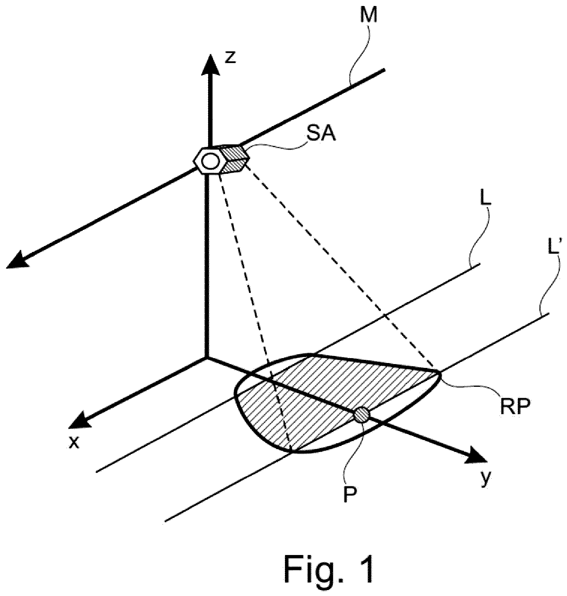

Zum besseren Verständnis wird zunächst anhand von Fig. 1 das Prinzip der SAR-Messung anhand der von einem Satelliten ausgesendeten Radarstrahlung erläutert. Der in Fig. 1 dargestellte Satellit ist mit dem Bezugszeichen SA angedeutet und bewegt sich in Richtung des dargestellten Pfeils M, welcher der x-Richtung des in Fig. 1 wiedergegebenen kartesischen Koordinatensystems entspricht. Diese x-Richtung wird üblicherweise auch als Azimut bezeichnet. Der Satellit SA, dessen Höhe über der Erdoberfläche durch die z-Koordinate des Koordinatensystems repräsentiert wird, sendet während seiner Bewegung kontinuierlich mit einer vorbestimmten Pulswiederholfrequenz Radarpulse in Richtung zur Erdoberfläche aus, wobei die Kontur eines gerade ausgesendeten Radarpulses auf der Erdoberfläche mit RP bezeichnet ist. Von jedem ausgesendeten Radarpuls wird das Radarecho erfasst, indem die an der Erdoberfläche reflektierte Radarstrahlung in die Richtung y des kartesischen Koordinatensystems abgetastet wird. Die Richtung y wird üblicherweise auch als Bodenentfernung (Ground-Range) bezeichnet.

In dem dargestellten Ausführungsbeispiel werden bei der Auswertung nur Informationen der Radarstrahlung zwischen den beiden Linien L und L' erfasst, die einen Abstand von mehreren Kilometern (z.B. 30 km) aufweisen. Dies wird auch durch den schraffierten Bereich innerhalb des Radarpulses RP angedeutet. Als analoge Rohdaten der SAR-Messung erhält man für eine Vielzahl von Radarpulsen und somit für eine Vielzahl von Azimut-Positionen jeweils eine Vielzahl von analogen Datenabtastungen (auch als Datensamples bezeichnet), welche jeweils einer Range-Position entsprechen. Eine entsprechende Abtastung wird dabei durch ein komplexes Signal mit einer Amplitude und einer Phase repräsentiert.

Das Prinzip der SAR-Messung beruht nunmehr darauf, dass jeweilige Punkte auf der Erdoberfläche mehrfach aus unterschiedlichen Blickwinkeln aufgrund der Bewegung des Satelliten SA erfasst werden. Dies wird in Fig. 1 für den Punkt P verdeutlicht. Dieser Punkt P weist in dem dargestellten Szenario den geringstmöglichen Abstand zum Satelliten SA auf. Durch Bewegung des Satelliten in Richtung M wird dieser Abstand immer größer. Vor Erreichen der in Fig. 1 dargestellten Position wurde dieser Abstand immer kleiner. Aufgrund des Doppler-Effekts kommt es bei der Erfassung des Radarechos zu einer Frequenzverschiebung, die geeignet ausgewertet werden kann, wodurch schließlich für die Punkte der Erdoberfläche, an denen die Radarpulse reflektiert werden, eine Amplituden- und Phaseninformation und somit ein Bildpunkt der Erdoberfläche erhalten wird. Die entsprechende Berechnung von Bildpunkten der Erdoberfläche aus SAR-Rohdaten ist dem Fachmann hinlänglich bekannt und wird deshalb nicht weiter im Detail erläutert. Mit dem SAR-Messverfahren wird durch eine Vielzahl von Radarpulsen eines Radarsenders kleiner Apertur eine größere synthetische Apertur entsprechend der Ausdehnung des Radarpulses auf der Erdoberfläche simuliert.

In dem Szenario der Fig. 1 befinden sich sowohl der Sender der Radarstrahlung als auch der Empfänger des Radarechos innerhalb des Satelliten SA. Mit dieser Konstellation können mittels einer an sich bekannten SAR-Prozessierung zweidimensionale SAR-Bilder der Erdoberfläche ermittelt werden. In einer anderen Konstellation wird die SAR-Messung durch zwei, sich synchron bewegende Satelliten durchgeführt. Dabei werden die Radarpulse von einem Sender auf einem der Satelliten ausgesendet und das entsprechende Radarecho sowohl von einem Empfänger auf dem einen Satelliten als auch von einem Empfänger auf dem anderen Satelliten empfangen. Auf diese Weise wird die gleiche Szene aus unterschiedlichen Blickwinkeln aufgenommen. Die hierdurch erhaltenen zweidimensionalen SAR-Bilder werden dann rechnergestützt interferometrisch überlagert, um hierdurch ein dreidimensionales Bild der Erdoberfläche mit entsprechenden Höheninformationen zu errechnen. Alternativ kann der gleiche SAR-Satellit über das gleiche Gebiet auf der Erdoberfläche zweimal fliegen, um zwei SAR-Bilder zu erhalten, die interferometrisch prozessiert werden.

Im Rahmen einer SAR-Messung werden die in den entsprechenden Satelliten empfangenen SAR-Rohdaten zunächst mit einem A/D-Wandler digitalisiert und anschließend an eine Bodenstation zur weiteren Verarbeitung übermittelt. Oftmals wird dabei ein A/D-Wandler verwendet, der aus den Rohdaten 8-Bit-Werte erzeugt. Es können aber auch andere Arten von Wandlern eingesetzt werden, welche digitale Werte mit längerer oder kürzerer Bitlänge generieren. Die mit dem A/D-Wandler digitalisierten SAR-Rohdaten stellen die digitalen SAR-Rohdaten im Sinne der Patentansprüche dar. Dabei entspricht ein Rohdatensatz im Sinne der Patentansprüche den durch einen jeweiligen Empfänger empfangenen (digitalisierten) Abtastungen der digitalen SAR-Rohdaten für eine vorgegebene Datenakquisition, d.h. einem vorgegebenen, durch den oder die Satelliten überflogenem Gebiet auf der Erdoberfläche.

Im Rahmen der weiteren Verarbeitung der digitalen SAR-Rohdaten in der Bodenstation werden dann die oben beschriebenen zweidimensionalen bzw. dreidimensionalen Bilder der Erdoberfläche errechnet. Da die Speicherressourcen im Satelliten und die Datenrate zur Übermittlung der Rohdaten an den Boden begrenzt sind, werden die digitalen SAR-Rohdaten jedoch noch vor deren Übermittlung an den Boden quantisiert. Im Rahmen der Quantisierung werden Quantisierungsstufen basierend auf kürzeren Bitwerten den digitalen Signalen zugeordnet. Beispielsweise kann bei der Quantisierung die ursprüngliche Bitrate von 8 Bits pro Datensample auf eine Rate von 2 oder 3 Bits herabgesetzt werden.

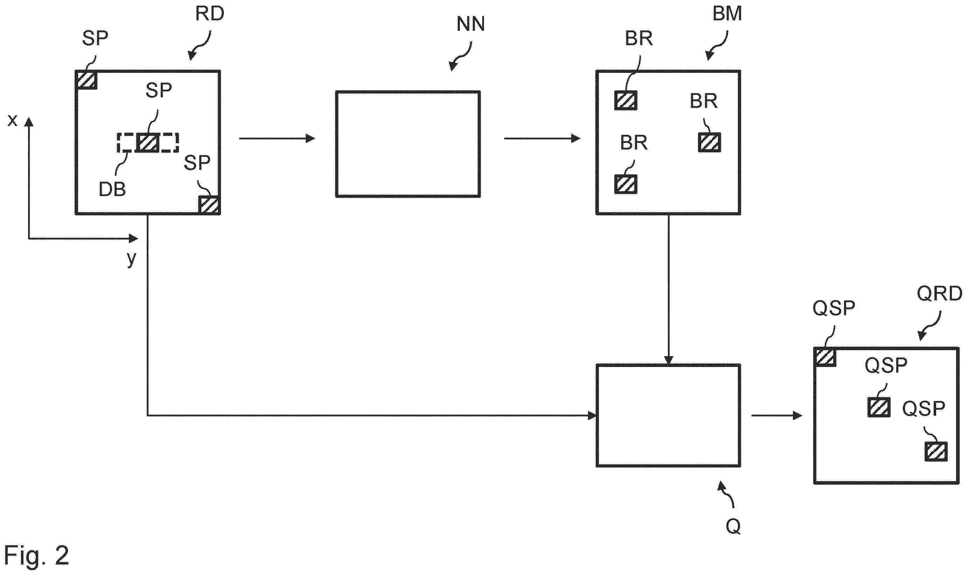

Erfindungsgemäß wird zur Quantisierung der digitalen SAR-Rohdaten ein datengetriebenes Modell verwendet, das mit geeigneten Trainingsdaten trainiert ist. Im Folgenden wird anhand von Fig. 2 eine Ausführungsform der Quantisierung mittels eines datengetriebenen Modells in der Form eines neuronalen Netzes beschrieben.

Fig. 2 zeigt schematisch einen zu quantisierenden Rohdatensatz RD in der Form einer zweidimensionalen Matrix. Diese Matrix enthält eine Vielzahl von digitalen Datenabtastungen, die lediglich beispielhaft durch schraffierte Quadrate SP angedeutet. Die gesamte Matrix ist dabei mit solchen Abtastungen besetzt. Die Abtastungen wurden für eine Vielzahl von Azimut-Positionen und eine Vielzahl von Range-Positionen ermittelt, wobei in Fig. 2 die Azimut-Richtung durch die x-Achse und die Range-Richtung durch die y-Achse eines zweidimensionalen kartesischen Koordinatensystems angedeutet ist.

Im Rahmen der Quantisierung wird der Rohdatensatz RD zunächst in eine Vielzahl von gleich großen Datenblocks (BAQ-Blocks) DB eingeteilt, wobei in Fig. 2 lediglich beispielhaft ein Datenblock durch ein schraffiertes Rechteck wiedergegeben ist. Die Datenblocks enthalten mehrere zeitlich aufeinander folgende Abtastungen SP in Range-Richtung. Für jeden einzelnen Datenblock wird separat eine BAQ-Quantisierung durchgeführt, wie weiter unten noch erläutert wird. Die Bitrate (d.h. Anzahl von Bits pro quantisierter Datenabtastung) wird dabei variabel für jeden Datenblock in Abhängigkeit von Merkmalen festgelegt, die aus den Datenabtastungen des jeweiligen Datenblocks extrahiert werden. Herkömmlicherweise wird die Zuweisung der einzelnen Datenblocks zu einer entsprechenden Bitrate der Quantisierung explizit durch eine Vorschrift bzw. eine Regel implementiert, z.B. in der Form von Look-up-Tabellen, die im Satelliten SA hinterlegt sein können und gegebenenfalls auch eine A-Priori-Informationen enthalten, wie z.B. die lokale Verteilung von Rückstreusignalen für den gerade erfassten Abschnitt auf der Erdoberfläche. Demzufolge ist es erforderlich, dass eine große Datenmenge an den Satelliten SA hochgeladen werden muss, wofür ausreichend Bandbreite sowie ausreichend Speicherplatz auf dem Satelliten benötigt wird.

Im Rahmen der Erfindung wird die entsprechende Vorschrift bzw. Regel nunmehr nicht mehr explizit, sondern über ein gelerntes datengetriebenes Modell implementiert, das in der Ausführungsform der Fig. 2 ein neuronales Netz NN ist. Das neuronale Netz NN wurde vorab durch ein entsprechendes Training erzeugt, wobei dieses Training weiter unten erläutert wird und auch einen Bestandteil der Erfindung darstellt. Als neuronales Netz kann eine beliebige, an sich bekannte Netzstruktur aus einer Eingangsschicht, einer Vielzahl von dazwischen liegenden versteckten Schichten und einer Ausgangsschicht verwendet werden. Es hat sich jedoch gezeigt, dass ein sog. Convolutional Neural Network für die Verarbeitung von SAR-Rohdaten besonders geeignet ist. Solche Netze verwenden sog. Convolutional Layers, die die zugeführten Daten zunächst einer Faltung mit einem Filterkernel unterziehen.

Über die Eingangsschicht wird dem neuronalen Netz NN der zu quantisierende Rohdatensatz RD zugeführt, aus dem das neuronale Netz mittels seiner versteckten Schichten eine Bitraten-Information in der Form einer Bitratenkarte BM an seiner Ausgangsschicht berechnet. Die Bitratenkarte gibt für jeden Datenblock des Rohdatensatzes RD eine entsprechende Bitrate für die Quantisierung dieses Datenblocks an. Die Bitratenkarte BM ist in Fig. 2 lediglich schematisch dargestellt, wobei beispielhaft nur einige Einträge der Karte durch schraffierte Quadrate angedeutet sind. Jeder Eintrag der Karte repräsentiert eine entsprechende Bitrate BR. Die Position jedes Eintrags der Karte ist in an sich bekannter Weise mit einer Position eines Datenblocks in den Rohdaten RD verknüpft.

Basierend auf der mit dem neuronalen Netz NN ermittelten Bitratenkarte BM erfolgt dann die Quantisierung des Rohdatensatzes RD, wobei diese Quantisierung in Fig. 2 durch ein Rechteck Q angedeutet ist. Dabei wird jeder Datenblock DB des Rohdatendatensatzes RD separat mit der entsprechend zugeordneten Bitrate BR aus der Bitratenkarte BM quantisiert. Für die Quantisierung der einzelnen Datenblocks kann eine beliebige, an sich bekannte BAQ-Quantisierung genutzt werden, wie z.B. die BAQ-Quantisierung aus dem Dokument [1] oder [2]. Nach der Durchführung der Quantisierung Q mittels der Bitratenkarte BM wird schließlich der quantisierte Rohdatensatz QRD erhalten, in dem die einzelnen Datenabtastungen quantisiert und somit komprimiert sind. Beispielhaft sind in Fig. 2 einige der quantisierten Datenabtastungen durch schraffierte Quadrate dargestellt und mit Bezugszeichen QSP bezeichnet.

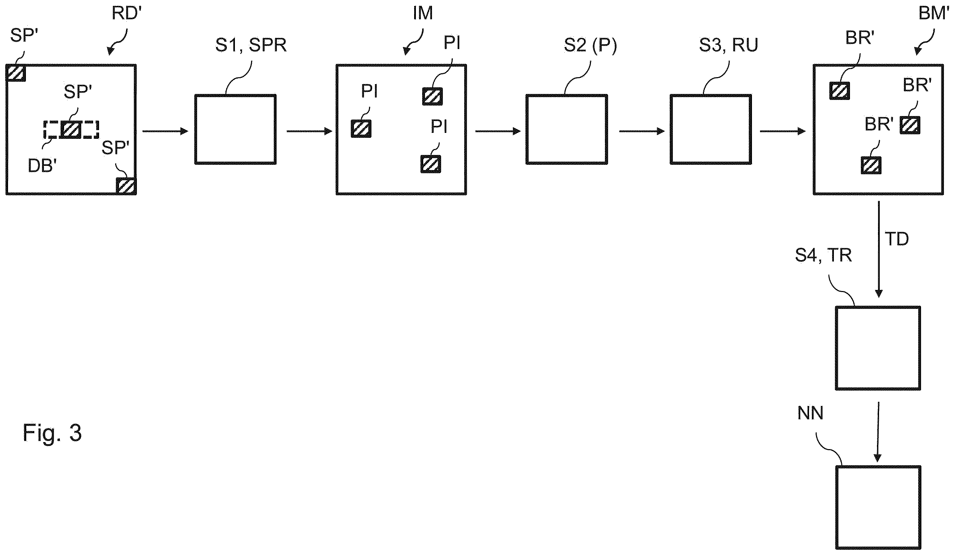

Nachfolgend wird anhand von Fig. 3 das Training des neuronalen Netzes NN aus Fig. 2 erläutert, wobei das Training in der Regel getrennt von der Quantisierung vorab am Boden einmalig durchgeführt wird und anschließend lediglich das trainierte neuronale Netz auf den Satelliten zur Verwendung für die Quantisierung hochgeladen wird. Mit dem trainierten neuronalen Netz wurde dabei eine Vorschrift RU zur Erzeugung der Bitratenkarte BM gelernt. In der hier beschriebenen Ausführungsform wird die Vorschrift gelernt, die in der Druckschrift [4] beschrieben ist und von Parameterwerten in der Form von Werten der Standardabweichung der Verteilung der rückgestreuten Signale in einem Ausschnitt um jeweilige Bildpunkte eines SAR-Bilds abhängt, das aus einem entsprechenden digitalen Rohdatensatz ohne Quantisierung ermittelt wird. Die genannte Vorschrift ist lediglich beispielhaft und es kann auch eine beliebige andere Vorschrift gelernt werden.

Gemäß Fig. 3 umfasst das Verfahren zur Erzeugung des trainierten neuronalen Netzes NN zunächst die Generierung geeigneter Trainingsdaten TD (Schritte S1 bis S3). Anschließend wird das eigentliche Training bzw. Lernen des neuronalen Netzes durchgeführt (Schritt S4). Zur Erzeugung entsprechender Trainingsdaten wird eine Vielzahl von vorbekannten Rohdatensätzen RD' verarbeitet, die analog zu dem Rohdatensatz RD der Fig. 2 aufgebaut sind. Das heißt, ein entsprechender vorbekannter Rohdatensatz RD' enthält eine Vielzahl von Datenakquisitionen SP' und ist analog zu der Struktur des Rohdatensatzes RD in Datenblocks (BAQ-Blocks) DB' aufgeteilt.

Für jeden der vorbekannten Rohdatensätze RD' wird nunmehr eine zugeordnete Bitratenkarte BM' bestimmt, die analog zu der Bitratenkarte BM der Fig. 2 aufgebaut ist und somit für die einzelnen Datenblocks DB' eines jeweiligen Rohdatensatzes RD' zugeordnete Bitraten BR' festlegt. Die Kombination aus einem Rohdatensatz RD' und einer Bitratenkarte BM' für diesen Rohdatensatz stellt dabei einen Trainingsdatensatz dar. Die Trainingsdaten setzen sich somit aus einer Vielzahl von Trainingsdatensätzen entsprechend der Anzahl von vorbekannten Rohdatensätzen zusammen.

Im Rahmen der Ermittlung einer Bitratenkarte BM' wird in Schritt S1 der Fig. 3 zunächst eine an sich bekannte SAR-Prozessierung SPR durchgeführt, bei welcher der Rohdatensatz RD' einer an sich bekannten Azimut- und Range-Fokussierung unterzogen wird, woraus ein komplexes zweidimensionales SAR-Bild IM gewonnen wird, das eine Vielzahl von Bildpunkten PI enthält, die lediglich beispielhaft durch einige schraffierte Quadrate angedeutet sind. Jeder Bildpunkt entspricht einem kleinen Ausschnitt auf der Erdoberfläche mit einer entsprechenden Amplitude und einer entsprechenden Phase. Ein jeweiliger Bildpunkt kann mit einer an sich bekannten Methodik räumlich mit einem Datenblock DB' in den Rohdaten RD' verknüpft werden.

In einem Schritt S2 werden aus dem gewonnenen SAR-Bild IM Werte eines Parameters P extrahiert. In der hier beschriebenen Ausführungsform handelt es sich bei dem Parameter um die Standardabweichung der Verteilung des rückgestreuten Signals in einen Ausschnitt um einen Bildpunkt des SAR-Bilds IM, wobei Werte dieses Parameters für alle Bildpunkte im SAR-Bild bestimmt werden. In Abhängigkeit von diesen Parameterwerten wird dann in Schritt S3 mittels der Regel RU die Bitratenkarte BM' bestimmt. Mit anderen Worten gibt die Regel für einen entsprechenden Parameterwert eines Bildpunkts PI und somit für einen verknüpften Datenblock DB' die für diesen Datenblock zu verwendende Bitrate BR' an.

In der hier beschriebenen Ausführungsform wird die in der Druckschrift [4] beschriebene Regel bzw. Vorschrift verwendet. Es können jedoch auch beliebige andere Vorschriften genutzt werden, die von anderen oder weiteren Parameterwerten des SAR-Bilds oder gegebenenfalls auch von Parameterwerten abhängen, die sich aus einer weitergehenden SAR-Prozessierung ergeben. Beispiele von solchen Parameterwerten (Signal-zu-Quantisierungsrauschen-Verhältnis, Kohärenzverlust, Standardabweichung der Verteilung des durch die Quantisierung versachten Phasenfehlers) wurden weiter oben beschrieben. In einer abgewandelten Ausführungsform ist es auch möglich, dass die Regel RU Parameter verwendet, die direkt aus den Datenabtastungen eines jeweiligen Datenblocks ohne Zwischenschaltung einer SAR-Prozessierung SPR abgeleitet werden. Eine solche Regel ist beispielweise in der oben erwähnten Druckschrift [3] beschrieben.

Als Ergebnis des Schritts S3 erhält man schließlich für jeden Rohdatensatz RD' einen Trainingsdatensatz aus Rohdatensatz RD' und zugeordneter Bitratenkarte BM'. Die Gesamtheit der Trainingsdatensätze repräsentiert gemäß Fig. 3 die Trainingsdaten TD. Anschließend werden diese Trainingsdaten in an sich bekannter Weise dazu genutzt, um im Rahmen eines überwachten Lernens in Schritt S4 der Fig. 3 ein Training TR des entsprechenden, zunächst untrainierten neuronalen Netzes durchzuführen. Als Ergebnis erhält man das trainierte neuronale Netz NN, das dann auf den Satelliten hochgeladen wird und dort zur Quantisierung gemäß dem Verfahren der Fig. 2 genutzt wird.

Die im Vorangegangenen beschriebenen Ausführungsformen der Erfindung weisen eine Reihe von Vorteilen auf. Insbesondere wird erstmalig eine adaptive BAQ-Quantisierung, bei der Datenblocks der SAR-Rohdaten mit unterschiedlichen Bitraten quantisiert werden können, mit einem neuronalen Netz kombiniert, wobei das neuronale Netz nach entsprechendem Training die zu verwendenden Bitraten für die einzelnen Datenblocks ausgibt. Es ist somit nicht mehr erforderlich, dass vorab große Datenmengen in der Form von Look-up-Tabellen bzw. anderen A-Priori-Informationen im entsprechenden Quantisierer hinterlegt werden. Es muss lediglich das gelernte neuronale Netz im Quantisierer gespeichert werden. Dabei kann das neuronale Netz sehr recheneffizient mittels an sich bekannter FPGAs (FPGA = Field Programmable Gate Array) implementiert werden.

### Literaturverzeichnis:

[1] El Boustani, A.; Brunham, K.; Kinsner, W.: "A Review of Current Raw SAR Data Compression Techniques", Electrical and Computer Engineering, Canadian Conference on, 2001, Vol. 2, Seiten 925 - 930
[2] US 6,255,987 B1
[3] E. Attema, C. Cafforio, M. Gottwald, P. Guccione, A. M. Guarnieri, F. Rocca, P. Snoeij: "Flexible Dynamic Block Adaptive Quantization for Sentinel-1 SAR Missions", IEEE Geoscience and Remote Sensing Letters, Vol. 7, Nr. 4, Seiten 766-770, October 2010
[4] M. Martone, N. Gollin, P. Rizzoli, G. Krieger: "Performance-Optimized Quantization for SAR and InSAR Applications", IEEE Transactions on Geoscience and Remote Sensing, Vol. 60, Seiten 1-22, 2022
[5] DE 10 2012 209 113 B4
[6] Zhu Xiao Xiang et al: "Deep Learning Meets SAR: Concepts, models, pitfalls, and perspectives", IEEE Geoscience and Remote Sensing Magazine, Vol. 9, Nr. 4, 9. Februar 2021, Seiten 143-172

## Patentansprüche

1. Verfahren zur rechnergestützten Erzeugung eines datengetriebenen Modells für die rechnergestützte Verarbeitung von digitalen SAR-Rohdaten, welche die rückgestreuten Radarechos von Radarpulsen (RP) umfassen, wobei die Radarpulse (RP) von einem oder mehreren Sendern zumindest eines Objekts (SA) ausgesendet wurden, das sich in einer ersten Richtung (x) bewegt, und die Radarechos von einem oder mehreren Empfängern des zumindest einen Objekts (SA) empfangen wurden, wobei die SAR-Rohdaten für jeden Empfänger einen Rohdatensatz (RD) aus einer Vielzahl von zeitlich aufeinander folgenden Datenabtastungen (SP) enthalten, denen jeweils eine Position in der ersten Richtung (x) und eine Position in einer zweiten Richtung (y) senkrecht zur ersten Richtung (x) zugeordnet sind, wobei im Rahmen der Verarbeitung der SAR-Rohdaten Datenblocks (DB) von zeitlich aufeinander folgenden Datenabtastungen (SP) des Rohdatensatzes (RD) separat mit einer dem jeweiligen Datenblock (DB) zugeordneten Bitrate (BR), welche die Anzahl von Bits pro quantisierter Datenabtastung (QSP) im jeweiligen Datenblock (DB) festlegt, unter Verwendung einer Bitraten-Information (BM) quantisiert werden, wobei die Bitraten-Information (BM) für jeden Datenblock (DB) die zugeordnete Bitrate (BR) angibt und das datengetriebene Modell zur Ermittlung der Bitraten-Information (BM) vorgesehen ist, wobei die Erzeugung des datengetriebenen Modells folgende Schritte umfasst:
- Generierung von Trainingsdaten (TD), indem für eine Vielzahl von unterschiedlichen vorbekannten Rohdatensätzen (RD') jeweils eine Bitraten-Information (BM') für Datenblocks (DB') eines jeweiligen vorbekannten Rohdatensatzes (RD') basierend auf einer Vorschrift erzeugt wird, welche von Werten zumindest eines Parameters (P) abhängt, die aus zumindest dem jeweiligen vorbekannten Rohdatensatz (RD') gewonnen werden;
- Trainieren eines neuronalen Netzes (NN) mit den Trainingsdaten (TD), wobei das neuronale Netz (NN) einen Eingang zur Eingabe eines Rohdatensatzes (RD) und einen Ausgang zur Ausgabe der Bitraten-Information (BM) für den eingegebenen Rohdatensatz (RD) enthält, wobei das trainierte neuronale Netz (NN) das erzeugte datengetriebene Modell darstellt.

2. Verfahren nach Anspruch 1, **dadurch gekennzeichnet, dass** im Rahmen der Generierung der Trainingsdaten (TD) für einen jeweiligen vorbekannten Rohdatensatz (RD') eine SAR-Prozessierung (SPR) durchgeführt wird, welche die Ermittlung von einem oder mehreren SAR-Bildern (IM) aus zumindest dem jeweiligen vorbekannten Rohdatensatz (RD') enthält, wobei aus Informationen, welche die SAR-Prozessierung (SPR) liefert, die Werte des zumindest einen Parameters (P) gewonnen werden, wobei die Werte des zumindest einen Parameters (P) vorzugsweise Qualitätswerte für ein aus der SAR-Prozessierung gewonnenes SAR-Produkt sind.

3. Verfahren nach Anspruch 2, **dadurch gekennzeichnet, dass** der zumindest eine Parameter (P) die Standardabweichung der Verteilung der rückgestreuten Signale in einem Ausschnitt um einen Bildpunkt (PI) eines SAR-Bilds (IM) umfasst, das für den jeweiligen vorbekannten Rohdatensatz (RD') ohne Quantisierung oder nach einer Quantisierung mit konstanter Bitrate ermittelt wird, wobei Werte der Standardabweichung für eine Vielzahl von Bildpunkten im SAR-Bild (IM) ermittelt werden.

4. Verfahren nach Anspruch 2 oder 3, **dadurch gekennzeichnet, dass** der zumindest eine Parameter (P) das Signal-zu-Quantisierungsrauschen-Verhältnis in einem Ausschnitt um einen Bildpunkt (PI) eines SAR-Bilds (IM) umfasst, das für den jeweiligen vorbekannten Rohdatensatz (RD') nach einer Quantisierung mit konstanter Bitrate ermittelt wird, wobei Werte des Signal-zu-Quantisierungsrauschen-Verhältnisses für eine Vielzahl von Bildpunkten (PI) in mehreren, für den jeweiligen vorbekannten Rohdatensatz (RD') ermittelten SAR-Bildern (IM) ermittelt werden, wobei sich die mehreren SAR-Bilder (IM) in der Bitrate der Quantisierung des jeweiligen vorbekannten Rohdatensatzes (RD') unterscheiden.

5. Verfahren nach einem der Ansprüche 2 bis 4, **dadurch gekennzeichnet, dass** der zumindest eine Parameter (P) den durch Quantisierung verursachten Kohärenzverlust in einem Ausschnitt um einen Bildpunkt eines SAR-Interferogramms umfasst, das aus dem jeweiligen vorbekannten Rohdatensatz (RD') und zumindest einem weiteren vorbekannten Rohdatensatz nach einer Quantisierung mit konstanter Bitrate ermittelt wird, wobei Werte des durch Quantisierung verursachten Kohärenzverlustes für eine Vielzahl von Bildpunkten für mehrere SAR-Interferogramme ermittelt werden, wobei sich die mehreren SAR-Interferogramme in der Bitrate der Quantisierung des jeweiligen vorbekannten Rohdatensatzes (RD') und des zumindest einen weiteren vorbekannten Rohdatensatzes unterscheiden.

6. Verfahren nach einem der Ansprüche 2 bis 4, **dadurch gekennzeichnet, dass** der zumindest eine Parameter (P) die Standardabweichung der Verteilung des durch Quantisierung verursachten Phasenfehlers in einem Ausschnitt um einen Bildpunkt eines SAR-Interferogramms umfasst, das aus dem jeweiligen vorbekannten Rohdatensatz (RD') und zumindest einem weiteren vorbekannten Rohdatensatz nach einer Quantisierung mit konstanter Bitrate ermittelt wird, wobei Werte der Standardabweichung der Verteilung des durch Quantisierung verursachten Phasenfehlers für eine Vielzahl von Bildpunkten für mehrere SAR-Interferogramme ermittelt werden, wobei sich die mehreren SAR-Interferogramme in der Bitrate der Quantisierung des jeweiligen vorbekannten Rohdatensatzes (RD') und des zumindest einen weiteren vorbekannten Rohdatensatzes unterscheiden.

7. Verfahren nach einem der Anspruch 1, **dadurch gekennzeichnet, dass** die Werte des zumindest einen Parameters (P) direkt aus den Datenabtastungen (SP') der Datenblocks (DB') des jeweiligen vorbekannten Rohdatensatz (RD') gewonnen werden, ohne dass für die Gewinnung des zumindest einen Parameters (P) eine SAR-Prozessierung (SPR) durchgeführt wird, welche die Ermittlung von SAR-Bildern (IM) aus zumindest dem jeweiligen vorbekannten Rohdatensatz enthält.

8. Verfahren nach Anspruch 7, **dadurch gekennzeichnet, dass** der zumindest eine Parameter (P) das mittlere Signal-zu-Rausch-Verhältnis der Datenabtastungen (SP') in einem Datenblock (DB') in dem jeweiligen vorbekannten Rohdatensatz (RD') ist, wobei Werte des Signal-zu-Rausch-Verhältnisses für jeden Datenblock (DB') in dem jeweiligen vorbekannten Rohdatensatz (RD') ermittelt werden.

9. Verfahren nach einem der vorhergehenden Ansprüche, **dadurch gekennzeichnet, dass** das neuronale Netz (NN) ein Convolutional Neural Network ist.

10. Verfahren nach einem der vorhergehenden Ansprüche, **dadurch gekennzeichnet, dass** das neuronale Netz (NN) ein tiefes neuronales Netz ist.

11. Verfahren nach einem der vorhergehenden Ansprüche, **dadurch gekennzeichnet, dass** das Trainieren des neuronalen Netzes (NN) basierend auf einem überwachten Lernen erfolgt, dessen Optimierungsziel durch ein Klassifikationsproblem repräsentiert wird, bei dem die Bitraten (BR) der jeweiligen Datenblocks (DB) in der Bitraten-Information (BM) am Ausgang des neuronalen Netzes (NN) jeweilige Klassen aus einer Vielzahl von Klassen darstellen.

12. Verfahren nach einem der Ansprüche 1 bis 10, **dadurch gekennzeichnet, dass** das Trainieren des neuronalen Netzes (NN) basierend auf einem überwachten Lernen erfolgt, dessen Optimierungsziel durch ein Regressionsproblem repräsentiert wird, bei dem die Bitraten (BR) der jeweiligen Datenblocks (DB) in der Bitraten-Information (BM) am Ausgang des neuronalen Netzes (NN) jeweils eine positive reelle Zahl darstellen.

13. Verfahren zur rechnergestützten Verarbeitung von digitalen SAR-Rohdaten, welche die rückgestreuten Radarechos von Radarpulsen (RP) umfassen, wobei die Radarpulse (RP) von einem oder mehreren Sendern zumindest eines Objekts (SA) ausgesendet wurden, das sich in einer ersten Richtung (x) bewegt, und die Radarechos von einem oder mehreren Empfängern des zumindest einen Objekts (SA) empfangen wurden, wobei die SAR-Rohdaten für jeden Empfänger einen Rohdatensatz (RD) aus einer Vielzahl von zeitlich aufeinander folgenden Datenabtastungen (SP) enthalten, denen jeweils eine Position in der ersten Richtung (x) und eine Position in einer zweiten Richtung (y) senkrecht zur ersten Richtung (x) zugeordnet sind, wobei im Rahmen der rechnergestützten Verarbeitung der SAR-Rohdaten Datenblocks (DB) von zeitlich aufeinander folgenden Datenabtastungen (SP) des Rohdatensatzes (RD) separat mit einer dem jeweiligen Datenblock (DB) zugeordneten Bitrate (BR), welche die Anzahl von Bits pro quantisierter Datenabtastung (QSP) im jeweiligen Datenblock (DB) festlegt, unter Verwendung einer Bitraten-Information (BM) quantisiert werden, wobei die Bitraten-Information für jeden Datenblock (DB) die zugeordnete Bitrate (BR) angibt, wobei die Bitraten-Information (BM) mit einem datengetriebenen Modell generiert wird, das mit einem Verfahren nach einem der Ansprüche 1 bis 12 erzeugt wurde.

14. Verfahren nach Anspruch 13, **dadurch gekennzeichnet, dass** die quantisierten Datenabtastungen (QSP) auf dem zumindest einen Objekt (SA) ermittelt werden und anschließend an eine Bodenstation übertragen werden.

15. Vorrichtung zur rechnergestützten Verarbeitung von digitalen SAR-Rohdaten, welche die rückgestreuten Radarechos von Radarpulsen (RP) umfassen, wobei die Radarpulse (RP) von einem oder mehreren Sendern zumindest eines Objekts (SA) ausgesendet wurden, das sich in einer ersten Richtung (x) bewegt, und die Radarechos von einem oder mehreren Empfängern des zumindest einen Objekts (SA) empfangen wurden, wobei die SAR-Rohdaten für jeden Empfänger einen Rohdatensatz (RD) aus einer Vielzahl von zeitlich aufeinander folgenden Datenabtastungen (SP) enthalten, denen jeweils eine Position in der ersten Richtung (x) und eine Position in einer zweiten Richtung (y) senkrecht zur ersten Richtung (x) zugeordnet sind, wobei die Vorrichtung einen Quantisierer umfasst, der dazu eingerichtet ist, im Rahmen der rechnergestützten Verarbeitung der SAR-Rohdaten Datenblocks (DB) von zeitlich aufeinander folgenden Datenabtastungen (SP) des Rohdatensatzes (RD) separat mit einer dem jeweiligen Datenblock (DB) zugeordneten Bitrate (BR), welche die Anzahl von Bits pro quantisierter Datenabtastung (QSP) im jeweiligen Datenblock (DB) festlegt, unter Verwendung einer Bitraten-Information (BM) zu quantisieren, wobei die Bitraten-Information für jeden Datenblock (DB) die zugeordnete Bitrate (BR) angibt, wobei der Quantisierer zur Generierung der Bitraten-Information (BM) ein datengetriebenes Modell enthält, das mit einem Verfahren nach einem der Ansprüche 1 bis 12 erzeugt wurde.

16. Computerprogrammprodukt mit einem auf einem maschinenlesbaren Träger gespeicherten Programmcode zur Durchführung eines Verfahrens nach einem der Ansprüche 1 bis 14, wenn der Programmcode auf einem Rechner ausgeführt wird.

17. Computerprogramm mit einem Programmcode zur Durchführung eines Verfahrens nach einem der Ansprüche 1 bis 14, wenn der Programmcode auf einem Computer ausgeführt wird.

## Claims

1. A method for computer-implemented generation of a data-driven model for the computer-implemented processing of digital SAR raw data which comprise the backscattered radar echoes of radar pulses (RP), wherein the radar pulses (RP) were emitted by one or more transmitters of at least one object (SA) which moves in a first direction (x), and the radar echoes were received by one or more receivers of the at least one object (SA), wherein the SAR raw data contain, for each receiver, a raw data set (RD) of a plurality of temporally successive data samples (SP), to each of which a position in the first direction (x) and a position in a second direction (y) perpendicular to the first direction (x) are assigned, wherein, in the course of the processing of the SAR raw data, data blocks (DB) of temporally successive data samples (SP) of the raw data set (RD) are quantised separately, using a bitrate information (BM), with a bitrate (BR) assigned to the respective data block (DB), which bitrate defines the number of bits per quantised data sample (QSP) in the respective data block (DB), wherein the bitrate information (BM) specifies, for each data block (DB), the assigned bitrate (BR), and the data-driven model is provided for determining the bitrate information (BM), wherein the generation of the data-driven model comprises the following steps:
- generating training data (TD) by generating, for each of a plurality of different pre-known raw data sets (RD'), respective bitrate information (BM') for data blocks (DB') of a respective pre-known raw data set (RD') based on a rule which depends on values of at least one parameter (P) which are obtained from at least the respective pre-known raw data set (RD');
- training a neural network (NN) with the training data (TD), wherein the neural network (NN) contains an input for inputting a raw data set (RD) and an output for outputting the bitrate information (BM) for the input raw data set (RD), wherein the trained neural network (NN) constitutes the generated data-driven model.

2. The method according to claim 1, **characterised in that**, in the course of the generation of the training data (TD), a SAR processing (SPR) is carried out for a respective pre-known raw data set (RD'), which SAR processing contains the determination of one or more SAR images (IM) from at least the respective pre-known raw data set (RD'), wherein the values of the at least one parameter (P) are obtained from information provided by the SAR processing (SPR), wherein the values of the at least one parameter (P) are preferably quality values for a SAR product obtained from the SAR processing.

3. The method according to claim 2, **characterised in that** the at least one parameter (P) comprises the standard deviation of the distribution of the backscattered signals in a region around a pixel (PI) of a SAR image (IM) which is determined for the respective pre-known raw data set (RD') without quantisation or after a quantisation with a constant bitrate, wherein values of the standard deviation are determined for a plurality of pixels in the SAR image (IM).

4. The method according to claim 2 or 3, **characterised in that** the at least one parameter (P) comprises the signal-to-quantisation-noise ratio in a region around a pixel (PI) of a SAR image (IM) which is determined for the respective pre-known raw data set (RD') after a quantisation with a constant bitrate, wherein values of the signal-to-quantisation-noise ratio are determined for a plurality of pixels (PI) in multiple SAR images (IM) determined for the respective pre-known raw data set (RD'), wherein the multiple SAR images (IM) differ in the bitrate of the quantisation of the respective pre-known raw data set (RD').

5. The method according to one of claims 2 to 4, **characterised in that** the at least one parameter (P) comprises the coherence loss caused by quantisation in a region around a pixel of a SAR interferogram which is determined from the respective pre-known raw data set (RD') and at least one further pre-known raw data set after a quantisation with a constant bitrate, wherein values of the coherence loss caused by quantisation are determined for a plurality of pixels for multiple SAR interferograms, wherein the multiple SAR interferograms differ in the bitrate of the quantisation of the respective pre-known raw data set (RD') and of the at least one further pre-known raw data set.

6. The method according to one of claims 2 to 4, **characterised in that** the at least one parameter (P) comprises the standard deviation of the distribution of the phase error caused by quantisation in a region around a pixel of a SAR interferogram which is determined from the respective pre-known raw data set (RD') and at least one further pre-known raw data set after a quantisation with a constant bitrate, wherein values of the standard deviation of the distribution of the phase error caused by quantisation are determined for a plurality of pixels for multiple SAR interferograms, wherein the multiple SAR interferograms differ in the bitrate of the quantisation of the respective pre-known raw data set (RD') and of the at least one further pre-known raw data set.

7. The method according to claim 1, **characterised in that** the values of the at least one parameter (P) are obtained directly from the data samples (SP') of the data blocks (DB') of the respective pre-known raw data set (RD'), without performing, for obtaining the at least one parameter (P), a SAR processing (SPR), which contains the determination of SAR images (IM) from at least the respective pre-known raw data set.

8. The method according to claim 7, **characterised in that** the at least one parameter (P) is the mean signal-to-noise ratio of the data samples (SP') in a data block (DB') in the respective pre-known raw data set (RD'), wherein values of the signal-to-noise ratio are determined for each data block (DB') in the respective pre-known raw data set (RD').

9. The method according to one of the preceding claims, **characterised in that** the neural network (NN) is a convolutional neural network.

10. The method according to one of the preceding claims, **characterised in that** the neural network (NN) is a deep neural network.

11. The method according to one of the preceding claims, **characterised in that** the training of the neural network (NN) is carried out based on supervised learning, the optimisation goal of which is represented by a classification problem in which the bitrates (BR) of the respective data blocks (DB) in the bitrate information (BM) at the output of the neural network (NN) constitute respective classes from a plurality of classes.

12. The method according to one of claims 1 to 10, **characterised in that** the training of the neural network (NN) is carried out based on supervised learning, the optimisation goal of which is represented by a regression problem in which the bitrates (BR) of the respective data blocks (DB) in the bitrate information (BM) at the output of the neural network (NN) each constitute a positive real number.

13. A method for computer-implemented processing of digital SAR raw data which comprise the backscattered radar echoes of radar pulses (RP), wherein the radar pulses (RP) were emitted by one or more transmitters of at least one object (SA) which moves in a first direction (x), and the radar echoes were received by one or more receivers of the at least one object (SA), wherein the SAR raw data contain, for each receiver, a raw data set (RD) of a plurality of temporally successive data samples (SP), to each of which a position in the first direction (x) and a position in a second direction (y) perpendicular to the first direction (x) are assigned, wherein, in the course of the computer-implemented processing of the SAR raw data, data blocks (DB) of temporally successive data samples (SP) of the raw data set (RD) are quantised separately, using a bitrate information (BM), with a bitrate (BR) assigned to the respective data block (DB), which bitrate defines the number of bits per quantised data sample (QSP) in the respective data block (DB), wherein the bitrate information specifies, for each data block (DB), the assigned bitrate (BR), wherein the bitrate information (BM) is generated with a data-driven model which was generated with a method according to one of claims 1 to 12.

14. The method according to claim 13, **characterised in that** the quantised data samples (QSP) are determined on the at least one object (SA) and are subsequently transmitted to a ground station.

15. An apparatus for computer-implemented processing of digital SAR raw data which comprise the backscattered radar echoes of radar pulses (RP), wherein the radar pulses (RP) were emitted by one or more transmitters of at least one object (SA) which moves in a first direction (x), and the radar echoes were received by one or more receivers of the at least one object (SA), wherein the SAR raw data contain, for each receiver, a raw data set (RD) of a plurality of temporally successive data samples (SP), to each of which a position in the first direction (x) and a position in a second direction (y) perpendicular to the first direction (x) are assigned, wherein the apparatus comprises a quantiser which is configured to quantise separately, in the course of the computer-implemented processing of the SAR raw data, data blocks (DB) of temporally successive data samples (SP) of the raw data set (RD), using a bitrate information (BM), with a bitrate (BR) assigned to the respective data block (DB), which bitrate defines the number of bits per quantised data sample (QSP) in the respective data block (DB), wherein the bitrate information specifies, for each data block (DB), the assigned bitrate (BR), wherein the quantiser contains, for generating the bitrate information (BM), a data-driven model which was generated with a method according to one of claims 1 to 12.

16. A computer program product with a program code stored on a machine-readable carrier for carrying out a method according to one of claims 1 to 14 when the program code is executed on a computer.

17. A computer program with a program code for carrying out a method according to one of claims 1 to 14 when the program code is executed on a computer.

## Revendications

1. Procédé de génération assistée par ordinateur d'un modèle piloté par les données pour le traitement assisté par ordinateur de données brutes de RSO numériques qui comprennent les échos radar rétrodiffusés d'impulsions radar (RP), dans lequel les impulsions radar (RP) ont été émises par un ou plusieurs expéditeurs d'au moins un objet (SA) qui se déplace dans une première direction (x), et les échos radar ont été reçus par un ou plusieurs destinataires de l'au moins un objet (SA), dans lequel les données brutes de RSO pour chaque destinataire contiennent un ensemble de données brutes (RD) provenant d'une pluralité d'explorations de données successives dans le temps (SP) auxquelles sont à chaque fois associées une position dans la première direction (x) et une position dans une seconde direction (y) perpendiculaire à la première direction (x), dans lequel des blocs de données (DB) d'explorations de données successives dans le temps (SP) de l'ensemble de données brutes (RD) sont quantifiés dans le cadre du traitement des données brutes de RSO séparément avec un débit binaire (BR) associé au bloc de données respectif (DB), qui définit le nombre de bits par exploration de données quantifiée (QSP) dans le bloc de données respectif (DB), en utilisant une information de débit binaire (BM), dans lequel l'information de débit binaire (BM) pour chaque bloc de données (DB) indique le débit binaire associé (BR) et le modèle piloté par les données est prévu pour la détermination de l'information de débit binaire (BM), dans lequel la génération du modèle piloté par les données comprend les étapes suivantes :
- génération de données d'entraînement (TD) en ce qu'une information de débit binaire (BM') pour des blocs de données (DB') d'un ensemble de données brutes respectif connu au préalable (RD') est à chaque fois générée pour une pluralité d'ensembles de données brutes différents connus au préalable (RD') en se basant sur une règle qui dépend de valeurs d'au moins un paramètre (P) qui sont obtenues à partir d'au moins l'ensemble de données brutes respectif connu au préalable (RD') ;
- entraînement d'un réseau neuronal (NN) avec les données d'entraînement (TD), dans lequel le réseau neuronal (NN) contient une entrée pour l'entrée d'un ensemble de données brutes (RD) et une sortie pour la sortie de l'information de débit binaire (BM) pour l'ensemble de données brutes entré (RD), dans lequel le réseau neuronal entraîné (NN) représente le modèle piloté par les données généré.

2. Procédé selon la revendication 1, **caractérisé en ce qu'**un traitement de RSO (SPR) est réalisé dans le cadre de la génération des données d'entraînement (TD) pour un ensemble de données brutes respectif connu au préalable (RD'), lequel contient la détermination d'une ou plusieurs images de RSO (IM) provenant d'au moins l'ensemble de données brutes respectif connu au préalable (RD'), dans lequel les valeurs de l'au moins un paramètre (P) sont obtenues à partir d'informations que livre le traitement de RSO (SPR), dans lequel les valeurs de l'au moins un paramètre (P) sont de préférence des valeurs de qualité pour un produit de RSO obtenu à partir du traitement de RSO.

3. Procédé selon la revendication 2, **caractérisé en ce que** l'au moins un paramètre (P) comprend l'écart type de la répartition des signaux rétrodiffusés dans une section autour d'un point d'image (PI) d'une image de RSO (IM) qui est déterminée pour l'ensemble de données brutes respectif connu au préalable (RD') sans quantification ou après une quantification avec un débit binaire constant, dans lequel des valeurs de l'écart type sont déterminées pour une pluralité de points d'image dans l'image de RSO (IM).

4. Procédé selon la revendication 2 ou 3, **caractérisé en ce que** l'au moins un paramètre (P) comprend le rapport de signal sur bruits de quantification dans une section autour d'un point d'image (PI) d'une image de RSO (IM) qui est déterminée pour l'ensemble de données brutes respectif connu au préalable (RD') après une quantification avec un débit binaire constant, dans lequel des valeurs du rapport de signal sur bruits de quantification sont déterminées pour une pluralité de points d'image (PI) dans plusieurs images de RSO (IM) déterminées pour l'ensemble de données brutes respectif connu au préalable (RD'), dans lequel la pluralité d'images de RSO (IM) se différencient dans le débit binaire de la quantification de l'ensemble de données brutes respectif connu au préalable (RD').

5. Procédé selon une des revendications 2 à 4, **caractérisé en ce que** l'au moins un paramètre (P) comprend la perte de cohérence provoquée par la quantification dans une section autour d'un point d'image d'un interférogramme de RSO qui est déterminé à partir de l'ensemble de données brutes respectif connu au préalable (RD') et d'au moins un autre ensemble de données brutes connu au préalable après une quantification avec un débit binaire constant, dans lequel des valeurs de la perte de cohérence provoquée par la quantification sont déterminées pour une pluralité de points d'image pour plusieurs interférogrammes de RSO, dans lequel la pluralité d'interférogrammes de RSO se différencient dans le débit binaire de la quantification de l'ensemble de données brutes respectif connu au préalable (RD') et de l'au moins un autre ensemble de données brutes connu au préalable.

6. Procédé selon une des revendications 2 à 4, **caractérisé en ce que** l'au moins un paramètre (P) comprend l'écart type de la répartition de l'erreur de phase provoquée par la quantification dans une section autour d'un point d'image d'un interférogramme de RSO qui est déterminé à partir de l'ensemble de données brutes respectif connu au préalable (RD') et d'au moins un autre ensemble de données brutes connu au préalable après une quantification avec un débit binaire constant, dans lequel des valeurs de l'écart type de la répartition de l'erreur de phase provoquée par la quantification sont déterminées pour une pluralité de points d'image pour plusieurs interférogrammes de RSO, dans lequel la pluralité d'interférogrammes de RSO se différencient dans le débit binaire de la quantification de l'ensemble de données brutes respectif connu au préalable (RD') et de l'au moins un autre ensemble de données brutes connu au préalable.

7. Procédé selon la revendication 1, **caractérisé en ce que** les valeurs de l'au moins un paramètre (P) sont directement obtenues à partir des explorations de données (SP') du bloc de données (DB') de l'ensemble de données brutes respectif connu au préalable (RD') sans qu'un traitement de RSO (SPR) ne soit réalisé pour l'obtention de l'au moins un paramètre (P), lequel contient la détermination d'images de RSO (IM) à partir d'au moins l'ensemble de données brutes respectif connu au préalable.

8. Procédé selon la revendication 7, **caractérisé en ce que** l'au moins un paramètre (P) est le rapport moyen de signal sur bruit des explorations de données (SP') dans un bloc de données (DB') dans l'ensemble de données brutes respectif connu au préalable (RD'), dans lequel des valeurs du rapport de signal sur bruit sont déterminées pour chaque bloc de données (DB') dans l'ensemble de données brutes respectif connu au préalable (RD').

9. Procédé selon une des revendications précédentes, **caractérisé en ce que** le réseau neuronal (NN) est un réseau neuronal convolutif.

10. Procédé selon une des revendications précédentes, **caractérisé en ce que** le réseau neuronal (NN) est un réseau neuronal profond.

11. Procédé selon une des revendications précédentes, **caractérisé en ce que** l'entraînement du réseau neuronal (NN) s'effectue en se basant sur un apprentissage surveillé dont l'objectif d'optimisation est représenté par un problème de classification dans le cadre duquel les débits binaires (BR) des blocs de données respectifs (DB) dans l'information de débit binaire (BM) à la sortie du réseau neuronal (NN) représentent des classes respectives parmi une pluralité de classes.

12. Procédé selon une des revendications 1 à 10, **caractérisé en ce que** l'entraînement du réseau neuronal (NN) s'effectue en se basant sur un apprentissage surveillé dont l'objectif d'optimisation est représenté par un problème de régression dans le cadre duquel les débits binaires (BR) des blocs de données respectifs (DB) dans l'information de débit binaire (BM) à la sortie du réseau neuronal (NN) représentent chacun un nombre réel positif.

13. Procédé de traitement assisté par ordinateur de données brutes de RSO numériques qui comprennent les échos radar rétrodiffusés d'impulsions radar (RP), dans lequel les impulsions radar (RP) ont été émises par un ou plusieurs expéditeurs d'au moins un objet (SA) qui se déplace dans une première direction (x), et les échos radar ont été reçus par un ou plusieurs destinataires de l'au moins un objet (SA), dans lequel les données brutes de RSO pour chaque destinataire contiennent un ensemble de données brutes (RD) provenant d'une pluralité d'explorations de données successives dans le temps (SP) auxquelles sont à chaque fois associées une position dans la première direction (x) et une position dans une seconde direction (y) perpendiculaire à la première direction (x), dans lequel des blocs de données (DB) d'explorations de données successives dans le temps (SP) de l'ensemble de données brutes (RD) sont quantifiés dans le cadre du traitement assisté par ordinateur des données brutes de RSO séparément avec un débit binaire (BR) associé au bloc de données respectif (DB), qui définit le nombre de bits par exploration de données quantifiée (QSP) dans le bloc de données respectif (DB), en utilisant une information de débit binaire (BM), dans lequel l'information de débit binaire (BM) pour chaque bloc de données (DB) indique le débit binaire associé (BR), dans lequel l'information de débit binaire (BM) est générée avec un modèle piloté par les données qui a été généré avec un procédé selon une des revendications 1 à 12.

14. Procédé selon la revendication 13, **caractérisé en ce que** les explorations de données quantifiées (QSP) sont déterminées sur l'au moins un objet (SA) et sont ensuite transmises à une station au sol.

15. Dispositif de traitement assisté par ordinateur de données brutes de RSO numériques qui comprennent les échos radar rétrodiffusés d'impulsions radar (RP), dans lequel les impulsions radar (RP) ont été émises par un ou plusieurs expéditeurs d'au moins un objet (SA) qui se déplace dans une première direction (x), et les échos radar ont été reçus par un ou plusieurs destinataires de l'au moins un objet (SA), dans lequel les données brutes de RSO pour chaque destinataire contiennent un ensemble de données brutes (RD) provenant d'une pluralité d'explorations de données successives dans le temps (SP) auxquelles sont à chaque fois associées une position dans la première direction (x) et une position dans une seconde direction (y) perpendiculaire à la première direction (x), dans lequel le dispositif comprend un quantificateur qui est configuré pour quantifier des blocs de données (DB) d'explorations de données successives dans le temps (SP) de l'ensemble de données brutes (RD) dans le cadre du traitement assisté par ordinateur des données brutes de RSO séparément avec un débit binaire (BR) associé au bloc de données respectif (DB), qui définit le nombre de bits par exploration de données quantifiée (QSP) dans le bloc de données respectif (DB), en utilisant une information de débit binaire (BM), dans lequel l'information de débit binaire (BM) pour chaque bloc de données (DB) indique le débit binaire associé (BR), dans lequel la quantificateur contient un modèle piloté par les données qui a été généré avec un procédé selon une des revendications 1 à 12 pour la génération de l'information de débit binaire (BM).

16. Produit de programme informatique avec un code de programme mémorisé sur un support lisible par machine pour la réalisation d'un procédé selon une des revendications 1 à 14 lorsque le code de programme est exécuté sur un ordinateur.

17. Programme informatique avec un code de programme pour la réalisation d'un procédé selon une des revendications 1 à 14 lorsque le code de programme est exécuté sur un ordinateur.
